(19) **Europäisches Patentamt European Patent Office Office européen des brevets**

(11) **EP 4 541 938 A1**

(12) **EUROPEAN PATENT APPLICATION**
published in accordance with Art. 153(4) EPC

(43) Date of publication:
**23.04.2025 Bulletin 2025/17**

(21) Application number: **23862752.5**

(22) Date of filing: **22.06.2023**

(51) International Patent Classification (IPC):
*C23C 26/00* (2006.01)   *C21D 1/18* (2006.01)
*C21D 9/00* (2006.01)   *C22C 19/03* (2006.01)
*C22C 19/05* (2006.01)   *C22C 38/00* (2006.01)
*C22C 38/06* (2006.01)   *C22C 38/60* (2006.01)
*C23C 14/14* (2006.01)   *C23C 14/16* (2006.01)
*C23C 28/00* (2006.01)   *C25D 5/26* (2006.01)
*C25D 5/48* (2006.01)

(52) Cooperative Patent Classification (CPC):
**C21D 1/18; C21D 9/00; C22C 19/03; C22C 19/05; C22C 38/00; C22C 38/06; C22C 38/60; C23C 14/14; C23C 14/16; C23C 26/00; C23C 28/00; C25D 5/36; C25D 5/48**

(86) International application number:
**PCT/JP2023/023229**

(87) International publication number:
**WO 2024/053207 (14.03.2024 Gazette 2024/11)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **05.09.2022 JP 2022141044**

(71) Applicant: **JFE Steel Corporation Tokyo 100-0011 (JP)**

(72) Inventors:
• **SATO, Rinta**
**Tokyo 100-0011 (JP)**
• **MAKIMIZU, Yoichi**
**Tokyo 100-0011 (JP)**

(74) Representative: **Scott, Stephen John YUJA IP LAW 4 Centenary House The Avenue York YO30 6AU (GB)**

(54) **STEEL SHEET FOR HOT PRESSING, HOT-PRESSED MEMBER AND METHOD FOR PRODUCING HOT-PRESSED MEMBER**

(57)    Provided is a steel sheet for hot pressing that has excellent suitability for high-speed heating, resists liquid metal embrittlement cracking, and has excellent paint adhesion after hot pressing. A steel sheet for hot pressing comprises: a base steel sheet; and a coating layer of 0.5 μm to 6.0 μm in thickness provided on both sides of the base steel sheet, wherein the coating layer is made of Ni or a Ni-based alloy, and a Zn content in the coating layer is 0 mass% to 30 mass%.

**EP 4 541 938 A1**

**Description**

TECHNICAL FIELD

The present disclosure relates to a steel sheet for hot pressing, a hot-pressed member, and a hot-pressed member production method.

BACKGROUND

In the recent automotive field, high strength steel sheets are used as materials for parts in order to meet the conflicting demands of improving automotive body strength and reducing weight, and the strength required of high strength steel sheets is increasing year by year.

However, improving the strength of a steel sheet typically causes a decrease in press formability, and thus makes it difficult to obtain a complex part shape. Examples of automotive parts with complex shapes include suspension parts such as chassis and structural framework parts such as B-pillars.

Against this background, the use of hot pressing technology, which performs hot forming rather than cold forming, is increasing. Hot pressing is a forming method in which a steel sheet is heated to an austenite temperature range, then press-formed at high temperature, and simultaneously quenched by contact with a mold. In hot pressing, press forming is performed in a state in which the strength of the steel sheet as a material is relatively low, and the strength is increased by subsequent quenching. It is thus possible to achieve high strength and also ensure press formability.

However, hot pressing has a problem in that, since the steel sheet is heated to high temperature as mentioned above, the surface of the steel sheet oxidizes and scale forms. In view of this, the use of steel sheets having, on their surface, a coating layer such as an Al or Al alloy coating layer, a Zn or Zn alloy coating layer, or an Al-Zn alloy coating layer as steel sheets for hot pressing is proposed.

For example, JP 2000-038640 A (PTL 1) proposes a steel sheet for hot pressing obtained by providing an aluminum coating layer on the surface of a steel sheet containing 0.15 % to 0.5 % carbon to suppress oxidation of the steel sheet during heating.

CITATION LIST

Patent Literature

PTL 1: JP 2000-038640 A

SUMMARY

(Technical Problem)

The conventional steel sheets for hot pressing such as the one proposed in PTL 1, however, have the following problems.

One problem is low suitability for high-speed heating. In order to perform hot pressing, the steel sheet for hot pressing needs to be heated in advance. Examples of methods of heating the steel sheet for hot pressing include atmosphere furnace heating, direct electrical resistance heating, and induction heating. In particular, direct resistance heating and induction heating are more energy efficient than atmosphere furnace heating, and therefore can reduce carbon dioxide emissions. In addition, direct resistance heating and induction heating allow the steel sheet for hot pressing to be heated at high speed, thus improving productivity.

Hence, in hot pressing, it is desirable to heat the steel sheet for hot pressing at high speed by direct resistance heating or induction heating. If the conventional Al or Al alloy coated steel sheet as proposed in PTL 1 is heated at high speed by direct resistance heating or induction heating, however, the magnetic field generated by the current causes the coating metal to flow, as a result of which the thickness of the coating layer in the final hot-pressed member varies. If the thickness of the coating layer varies greatly, the appearance quality and corrosion resistance after painting degrade. Accordingly, when hot pressing the Al or Al alloy coated steel sheet, there is no other choice but to use atmosphere furnace heating with a low heating rate. Hence, a steel sheet for hot pressing having excellent suitability for high-speed heating is needed.

Another problem is liquid metal embrittlement cracking. Liquid metal embrittlement (LME) is a phenomenon in which, when tensile stress is applied in a state in which liquid metal is in contact with the surface of solid metal, the solid metal becomes brittle. In hot pressing, when press forming is performed in a state in which metal contained in the coating layer is melted due to heating, liquid metal embrittlement cracking occurs at the bent part that is subjected to tensile stress.

Thus, the steel sheet for hot pressing is also required to resist liquid metal embrittlement cracking.

Furthermore, a hot-pressed member obtained by hot pressing a steel sheet for hot pressing is typically painted before use. Hence, the hot-pressed member finally produced from the steel sheet for hot pressing is required to have excellent paint adhesion.

It could therefore be helpful to provide a steel sheet for hot pressing and a hot-pressed member that can satisfy the following requirements (1) to (3):

(1) Excellent suitability for high-speed heating
(2) Resistance to liquid metal embrittlement cracking during hot press forming
(3) Excellent paint adhesion after hot pressing.

(Solution to Problem)

We thus provide the following.

1. A steel sheet for hot pressing, comprising: a base steel sheet; and a coating layer of 0.5 $\mu$m to 6.0 $\mu$m in thickness provided on both sides of the base steel sheet, wherein the coating layer is made of Ni or a Ni-based alloy, and a Zn content in the coating layer is 0 mass% to 30 mass%.
2. The steel sheet for hot pressing according to 1., wherein the Zn content in the coating layer is 0.5 mass% to 30 mass%.
3. The steel sheet for hot pressing according to 1. or 2., wherein the coating layer contains at least one selected from the group consisting of Al, Ti, V, Cr, Mn, Fe, Co, Mo, and W in a total amount of 50 mass% or less.
4. A hot-pressed member comprising: a base steel sheet; and a coating layer of 0.5 $\mu$m to 6.0 $\mu$m in thickness provided on both sides of the base steel sheet, wherein the coating layer is made of Ni or a Ni-based alloy, and a Zn content in the coating layer is 0 mass% to 30 mass%.
5. The hot-pressed member according to 4., wherein the Zn content in the coating layer is 0.5 mass% to 30 mass%.
6. The hot-pressed member according to 4. or 5., wherein the coating layer contains at least one selected from the group consisting of Al, Ti, V, Cr, Mn, Fe, Co, Mo, and W in a total amount of 50 mass% or less.
7. The hot-pressed member according to any one of 4. to 6., further comprising an oxide layer containing one or both of Mn and Fe and having a thickness of 0.1 $\mu$m to 5 $\mu$m, on the coating layer, wherein a total ratio of Mn and Fe to all metal elements contained in the oxide layer is 1 at% to 50 at%.
8. A hot-pressed member production method comprising hot pressing the steel sheet for hot pressing according to any one of 1. to 3. to obtain a hot-pressed member.

(Advantageous Effect)

The steel sheet for hot pressing according to the present disclosure has excellent suitability for high-speed heating, and does not vary in the thickness of the coating layer even when heated at high speed by direct resistance heating or induction heating. The steel sheet for hot pressing according to the present disclosure also resists liquid metal embrittlement cracking during hot press forming. Moreover, the hot-pressed member obtained by hot pressing the steel sheet for hot pressing according to the present disclosure has excellent paint adhesion.

DETAILED DESCRIPTION

Embodiments of the present disclosure will be described in detail below. The present disclosure is, however, not limited to such embodiments. The unit of content "%" in the chemical compositions of the coating layer and steel sheet represents "mass%" unless otherwise specified.

[Steel sheet for hot pressing]

A steel sheet for hot pressing in one embodiment of the present disclosure includes: a base steel sheet; and a coating layer of 0.5 $\mu$m to 6.0 $\mu$m in thickness provided on both sides of the base steel sheet. The coating layer is made of Ni or a Ni-based alloy, and the Zn concentration in the coating layer is 0 % to 30 %.

[[Coating layer]]

The coating layer may be a coating layer made of Ni (Ni coating layer) or a coating layer made of a Ni-based alloy (Ni-based alloy coating layer). As used herein, "Ni-based alloy" refers to an alloy having a Ni content of 50 % or more. In other words, the coating layer according to the present disclosure is a coating layer having a Ni content of 50 % or more.

In the heating process prior to hot pressing, the surface layer of the steel sheet is oxidized by oxygen or water vapor in the atmosphere. The steel sheet for hot pressing according to the present disclosure, however, includes a Ni or Ni alloy coating layer with a high melting point and oxidation resistance on its surface, so that the coating layer does not melt during heating and the formation of a thick oxide layer on the surface can be prevented. As a result, excellent paint adhesion can be achieved.

From the viewpoint of enhancing this effect, the Ni content in the coating layer is preferably 60 % or more, more preferably 70 % or more, and further preferably 80 % or more. The upper limit of the Ni content in the coating layer is not set, and may be 100 %.

Zn: 0 % to 30 %

If the coating layer contains a large amount of Zn, oxidation resistance decreases. In addition, Zn melts due to heating, and liquid metal embrittlement cracking occurs during hot forming. The Zn content in the coating layer is therefore 30 % or less, preferably 20 % or less, more preferably 10 % or less, and further preferably 5 % or less. Since the foregoing problems can be solved even if the coating layer does not contain Zn, the lower limit of the Zn content is 0 %. If the coating layer contains Zn, however, the chemical conversion coating formed in the chemical conversion treatment process, which is a prepainting treatment process, becomes denser, and paint adhesion is further improved. The Zn content in the coating layer is therefore preferably 0.5 % or more, more preferably 1 % or more, and further preferably 2 % or more.

The coating layer may optionally contain at least one selected from the group consisting of Al, Ti, V, Cr, Mn, Fe, Co, Mo, and W in a total amount of 50 % or less. Adding at least one of Al, Ti, V, Cr, Mn, Co, Mo, and W contributes to higher oxidation resistance. Since these elements are optionally added elements, the lower limit of the total content may be 0 %. In order to strengthen the oxidation resistance of the coating layer, the total content of these elements in the coating layer is preferably 1 % or more. In the case where the coating layer is formed by electroplating, Fe eluted from the base steel sheet into the plating bath may be incorporated into the coating layer. If the content of these elements is excessive, the Ni content in the coating layer decreases relatively, so that the function of the coating layer is impaired. The total content of these elements is therefore 50 % or less, preferably 40 % or less, more preferably 30 % or less, and further preferably 20 % or less. The Fe content in the coating layer is preferably 20 % or less, more preferably 5 % or less, and further preferably 1 % or less.

The coating layer in one embodiment of the present disclosure has a chemical composition containing, in mass%, Zn: 0 % to 30 %, and at least one selected from the group consisting of Al, Ti, V, Cr, Mn, Fe, Co, Mo, and W: 0 % to 50 % in total, with the balance consisting of Ni and inevitable impurities.

The preferred range of the content of each component described above also applies to the foregoing embodiment. For example, from the viewpoint of further improving paint adhesion, the Zn content is preferably 0.5 % or more, more preferably 1 % or more, and further preferably 2 % or more.

Thickness: 0.5 $\mu$m to 6.0 $\mu$m

When the steel sheet for hot pressing is heated, Ni in the coating layer and Fe in the base steel sheet interdiffuse and a Ni-based alloy layer with an increased Fe concentration forms in the surface layer of the hot-pressed member. If the thickness of the coating layer in the steel sheet for hot pressing is less than 0.5 $\mu$m, in the case where the steel sheet for hot pressing is heated at a high temperature exceeding 1000 °C, Fe that has diffused and reached the surface layer is oxidized and a thick and brittle Fe-containing oxide layer forms. When such a thick and brittle Fe-containing oxide exists, paint adhesion decreases. The thickness of the coating layer is therefore 0.5 $\mu$m or more. Given that higher corrosion resistance is achieved when the coating layer remaining after heating is thicker, the thickness of the coating layer is preferably 1.0 $\mu$m or more and more preferably 2.0 $\mu$m or more. If the thickness of the coating layer is more than 6.0 $\mu$m, surface roughness after heating increases and paint adhesion decreases. The thickness of the coating layer is therefore 6.0 $\mu$m or less, preferably 5.0 $\mu$m or less, and more preferably 4.0 $\mu$m or less.

The steel sheet for hot pressing according to the present disclosure has the coating layer on both sides. The thickness of the coating layer on one side may be the same as or different from the thickness of the coating layer on the other side, as long as the thickness of the coating layer on each side satisfies the foregoing condition.

[[Base steel sheet]]

The base steel sheet is not limited, and any steel sheet may be used. The base steel sheet may be any of a hot-rolled steel sheet and a cold-rolled steel sheet.

From the viewpoint of obtaining a hot-pressed member with a tensile strength exceeding 980 MPa class after hot pressing, the base steel sheet preferably has a chemical composition containing, in mass%, C: 0.05 % to 0.50 %, Si: 0.1 % to 1.0 %, Mn: 0.5 % to 3.0 %, P: 0.1 % or less, S: 0.01 % or less, Al: 0.10 % or less, and N: 0.01 % or less with the balance consisting of Fe and inevitable impurities. The reasons why this chemical composition is preferable are as follows.

C: 0.05 % to 0.50 %

Adding C forms hard microstructure such as martensite, with it being possible to enhance the strength of the steel sheet. In order to obtain a high strength exceeding 980 MPa class, the C content in the base steel sheet is preferably 0.05 % or more and more preferably 0.10 % or more. If the C content is more than 0.50 %, the toughness of the spot weld decreases. The C content is therefore preferably 0.50 % or less. The C content is more preferably 0.45 % or less, further preferably 0.43 % or less, and most preferably 0.40 % or less.

Si: 0.1 % to 1.0 %

Si is an effective element for strengthening steel and obtaining good material properties. In order to achieve this effect, the Si content is preferably 0.1 % or more and more preferably 0.2 % or more. If the Si content is more than 1.0 %, ferrite is stabilized and as a result quench hardenability decreases. The Si content is therefore preferably 1.0 % or less. The Si content is more preferably 0.4 % or less, and further preferably 0.3 % or less.

Mn: 0.5 % to 3.0 %

Mn is an element that contributes to improved strength of the steel sheet over a wide cooling rate range. In order to achieve this effect, the Mn content is preferably 0.5 % or more, more preferably 0.7 % or more, and further preferably 1.0 % or more. If the Mn content is more than 3.0 %, the effect of adding Mn is saturated. The Mn content is therefore preferably 3.0 % or less. The Mn content is more preferably 2.5 % or less, further preferably 2.0 % or less, and most preferably 1.5 % or less.

P: 0.1 % or less

If the P content is more than 0.1 %, P segregates to the austenite grain boundaries during casting, causing grain boundary embrittlement. As a result, local ductility decreases and the balance between the strength and ductility of the steel sheet deteriorates. The P content is therefore preferably 0.1 % or less. Although no lower limit is placed on the P content, the P content is preferably 0.01 % or more from the viewpoint of the refining cost.

S: 0.01 % or less

S forms inclusions such as MnS and causes degradation in impact resistance and cracking along the metal flow of the weld. It is thus desirable to reduce the S content as much as possible. The S content is preferably 0.01 % or less. From the viewpoint of ensuring good stretch flangeability, the S content is more preferably 0.005 % or less and further preferably 0.001 % or less. Although no lower limit is placed on the S content, the S content is preferably 0.0002 % or more from the viewpoint of the refining cost.

Al: 0.10 % or less

If the Al content is more than 0.10 %, the blanking workability and quench hardenability of the steel sheet decrease. The Al content is therefore preferably 0.10 % or less. The Al content is more preferably 0.07 % or less, and further preferably 0.04 % or less. Although no lower limit is placed on the Al content, the Al content is preferably 0.01 % or more from the viewpoint of ensuring the effect as a deoxidizer.

N: 0.01 % or less

If the N content is more than 0.01 %, AlN forms during hot rolling or during heating before hot pressing, and the blanking workability and quench hardenability of the steel sheet decrease. The N content is therefore preferably 0.01 % or less. Although no lower limit is placed on the N content, the N content is preferably 0.001 % or more from the viewpoint of the refining cost.

The chemical composition of the base steel sheet may optionally further contain at least one selected from the group consisting of Nb: 0.10 % or less, Ti: 0.10 % or less, B: 0.0002 % to 0.010 %, Cr: 0.1 % to 1.0 %, and Sb: 0.003 % to 0.10 %, for further property improvement.

Nb: 0.10 % or less

Nb is an effective element for strengthening steel. If the Nb content is excessive, however, the rolling load increases. Accordingly, in the case where Nb is contained, the Nb content is 0.10 % or less, preferably 0.06 % or less, and more preferably 0.03 % or less. The lower limit of the Nb content is not set, and may be 0 %. From the viewpoint of the refining cost, the Nb content is preferably 0.005 % or more.

Ti: 0.10 % or less

Ti is an effective element for strengthening steel, as with Nb. If the Ti content is excessive, however, shape fixability decreases. Accordingly, in the case where Ti is contained, the Ti content is 0.10 % or less, and preferably 0.06 % or less. The lower limit of the Ti content is not set, and may be 0 %. From the viewpoint of the refining cost, the Ti content is preferably 0.003 % or more.

B: 0.0002 % to 0.010 %

B is an element that has the effect of inhibiting the formation and growth of ferrite from austenite grain boundaries. In order to achieve this effect, in the case where B is contained, the B content is preferably 0.0002 % or more and more preferably 0.0010 % or more. If the B content is excessive, formability is significantly impaired. Accordingly, in the case where B is contained, the B content is 0.010 % or less, and preferably 0.005 % or less.

Cr: 0.1 % to 1.0 %

Cr is an element that improves quench hardenability and contributes to improved strength of the steel sheet. In order to achieve this effect, in the case where Cr is contained, the Cr content is 0.1 % or more and preferably 0.2 % or more. Since Cr is expensive, adding more than 1.0 % of Cr causes a significant increase in cost. Accordingly, in the case where Cr is contained, the C content is 1.0 % or less, preferably 0.5 % or less, and more preferably 0.3 % or less.

Sb: 0.003 % to 0.10 %

Sb is an element that has the effect of suppressing decarburization of the surface layer during the annealing process when producing the base steel sheet. In order to achieve this effect, in the case where Sb is contained, the Sb content is 0.003 % or more and preferably 0.005 % or more. If the Sb content is more than 0.10 %, the rolling load increases, as a result of which productivity decreases. Accordingly, in the case where Sb is contained, the Sb content is 0.10 % or less, preferably 0.05 % or less, and more preferably 0.03 % or less.

[Production method for steel sheet for hot pressing]

The steel sheet for hot pressing according to the present disclosure can be produced by any method without limitation. Preferred production conditions will be described below.

First, a base steel sheet is produced. The base steel sheet can typically be produced by rolling a steel slab obtained by casting. As the steel slab, a steel slab having the above-described chemical composition is preferably used.

In the rolling, a hot slab obtained by casting may be directly hot rolled (without reheating), or a cold slab decreased in temperature after casting may be reheated and hot rolled. A steel sheet obtained by directly rolling a hot slab and a steel sheet obtained by reheating and then rolling a cold slab differ little in properties. In the case of reheating a cold slab before hot rolling, the reheating temperature is not limited, but is preferably in the range of 1000 °C to 1300 °C from the viewpoint of productivity.

The hot rolling may be performed by either a normal hot rolling process or a continuous hot rolling process in which slabs are joined and rolled in finish rolling. The rolling finish temperature in the hot rolling is not limited, but is preferably higher than or equal to Ar3 transformation point from the viewpoint of productivity and sheet thickness accuracy.

The hot-rolled steel sheet obtained by the hot rolling is then cooled according to a conventional method. Here, the coiling temperature is preferably 550 °C or higher from the viewpoint of productivity. If the coiling temperature is excessively high, the pickling property degrades. The coiling temperature is therefore preferably 750 °C or lower. After the cooling, it is preferable to perform pickling according to a conventional method.

In the case of using a cold-rolled steel sheet as the base steel sheet, cold rolling is further preformed according to a conventional method after the pickling.

A coating layer is then formed on the surface of the resultant steel sheet. The method of forming the coating layer is not limited, and may be any method such as coating or plating, PVD, or clad rolling. Examples of the coating or plating include electroplating. Examples of the PVD include vacuum deposition, sputtering, and ion plating. In the case of using clad rolling, a layer having the desired composition is stacked on both sides of the base steel sheet and subjected to rolling.

The method of forming the coating layer is preferably selected depending on the composition of the coating layer to be formed. For example, in the case where the coating layer is a Ni layer, a Ni-Cr alloy layer, or a Ni-Zn alloy layer, the coating layer is preferably formed by electroplating, although the coating layer can also be formed by other methods without problems. In the case where the coating layer has a composition for which electrodeposition from an aqueous solution is difficult, such as a Ni-Ti alloy, the coating layer is preferably formed by PVD.

Regardless of which method is used to form the coating layer, the conditions are adjusted so that each of the coating layer on one side (front side) of the steel sheet and the coating layer on the other side (back side) of the steel sheet will have the desired thickness. For example, in the case of electroplating, the thickness of the coating layer on each side can be adjusted by changing one or both of the current density and the current passage time on the side.

[Hot-pressed member]

A hot-pressed member in one embodiment of the present disclosure includes: a base steel sheet; and a coating layer of 0.5 $\mu$m to 6.0 $\mu$m in thickness provided on both sides of the base steel sheet. The coating layer is made of Ni or a Ni-based alloy, and the Zn content in the coating layer is 0 % to 30 %.

For the base steel sheet and the coating layer, the above description of the base steel sheet and the coating layer in the steel sheet for hot pressing applies. In detail, as the base steel sheet of the hot-pressed member, the same steel sheet as the base steel sheet of the steel sheet for hot pressing may be used. As the coating layer of the hot-pressed member, the same coating layer as the coating layer of the steel sheet for hot pressing may be used. For example, the Zn content in the coating layer of the hot-pressed member is preferably 0.5 % or more, more preferably 1 % or more, and further preferably 2 % or more. The coating layer may contain at least one selected from the group consisting of Al, Ti, V, Cr, Mn, Fe, Co, Mo, and W in a total amount of 50 mass% or less.

[Oxide layer]

A hot-pressed member in another embodiment of the present disclosure further includes an oxide layer containing one or both of Mn and Fe and having a thickness of 0.1 $\mu$m to 5 $\mu$m, on the coating layer. In detail, the hot-pressed member in this embodiment includes: a base steel sheet; a coating layer of 0.5 $\mu$m to 6.0 $\mu$m in thickness provided on both sides of the base steel sheet; and an oxide layer of 0.1 $\mu$m to 5 $\mu$m in thickness provided on the coating layer.

The oxide layer is formed as a result of components contained in the coating layer or base steel sheet reacting with oxygen or water vapor in the atmosphere during the hot pressing process. The composition and thickness of the oxide layer vary depending on heating conditions such as heating temperature, heating time, and atmosphere. If the thickness of the oxide layer is more than 5 $\mu$m, painting layer adhesion decreases, making it impossible to obtain sufficient post-painting corrosion resistance. Accordingly, in the case where the oxide layer is present, the thickness of the oxide layer is 5 $\mu$m or less, preferably 3 $\mu$m or less, and more preferably 1 $\mu$m or less. From the viewpoint of painting layer adhesion, a thinner oxide layer is better. However, in order to make the oxide layer less than 0.1 $\mu$m thick, it is necessary to perform hot pressing in an atmosphere with an extremely low oxygen partial pressure or to perform a process of removing oxide after hot pressing, which increases production costs. The thickness of the oxide layer is therefore preferably 0.1 $\mu$m or more.

The oxide layer contains one or both of Mn and Fe. As a result of the oxide layer containing any of these elements, such component(s) is eluted into the chemical conversion treatment liquid in the chemical conversion treatment process. This promotes the formation of the chemical conversion coating, and thus achieves better paint adhesion. In order to achieve this effect, the total ratio of Mn and Fe to all metals contained in the oxide layer is 1 at% (atomic %) to 50 at%.

The thickness of the oxide layer can be measured by observing a cross section of the hot-pressed member using a scanning electron microscope (SEM). More specifically, the thickness of the oxide layer can be measured by the method described in the EXAMPLES section.

The ratio of Mn and Fe to all metals contained in the oxide layer can be measured by analyzing a cross section of the hot-pressed member using an electron probe microanalyzer (EPMA). More specifically, the ratio of Mn and Fe to all metals contained in the oxide layer can be measured by the method described in the EXAMPLES section.

[Hot-pressed member production method]

In one embodiment of the present disclosure, a steel sheet for hot pressing is hot pressed to produce a hot-pressed member. The method of hot pressing is not limited, and hot pressing may be performed according to a conventional method. Typically, a steel sheet for hot pressing is heated to a certain heating temperature (heating process), and then the steel sheet for hot pressing heated in the heating process is hot pressed (hot pressing process). Preferred hot pressing conditions will be described below.

If the heating temperature in the heating process is lower than the Ac3 transformation point of the base steel sheet, the strength of the resultant hot-pressed member is low. The heating temperature is therefore preferably higher than or equal to the Ac3 transformation point of the base steel sheet. The heating temperature is preferably 860 °C or higher. If the heating temperature is higher than 1000 °C, there is a possibility that the paint adhesion of the resultant hot-pressed member degrades as a result of an excessively thick oxide layer being formed through oxidation of the base metal or the coating layer. The heating temperature is therefore preferably 1000 °C or lower, more preferably 960 °C or lower, and further preferably 920 °C or lower. The Ac3 transformation point of the base steel sheet varies depending on the steel composition, and is determined by Formastor® (Formastor is a registered trademark in Japan, other countries, or both) testing.

The heating start temperature is not limited, but is typically room temperature.

The time (heating time) required for heating to the heating temperature from the heating start is not limited and may be any period of time. If the heating time is more than 300 seconds, however, the time of exposure to high temperatures is long, causing the oxide layer formed through oxidation of the base metal or the coating layer to be excessively thick. Hence, from the viewpoint of suppressing the decrease in paint adhesion caused by oxides, the heating time is preferably 100 seconds or less, more preferably 80 seconds or less, and further preferably 60 seconds or less. If the heating time is less than 3 seconds, stable heating is difficult. Accordingly, the heating time is preferably 3 seconds or more, more preferably 4 seconds or more, and further preferably 5 seconds or more.

Once the heating temperature has been reached, the steel sheet for hot pressing may be held at the heating temperature. In the case of holding the steel sheet for hot pressing at the heating temperature, the holding time is not limited and may be any period of time. If the holding time is more than 100 seconds, however, there is a possibility that the paint adhesion of the resultant hot-pressed member degrades as a result of an excessively thick oxide layer being formed through oxidation of the base metal or the coating layer. The holding time is therefore preferably 100 seconds or less, more preferably 60 seconds or less, and further preferably 20 seconds or less. Although no lower limit is placed on the holding time, the holding time is preferably 1 second or more from the viewpoint of homogeneously austenitizing the base steel sheet.

The atmosphere in the heating process is not limited. For example, the heating may be performed in an air atmosphere, or in an atmosphere into which air flows. From the viewpoint of reducing the amount of diffusible hydrogen remaining in the hot-pressed member, the dew point of the atmosphere is preferably 10 °C or lower. Although no lower limit is placed on the dew point, for example, the dew point may be -40 °C or higher.

The method of heating the steel sheet for hot pressing is not limited and may be any method. Examples of the heating method include furnace heating, electrical resistance heating, induction heating, high-frequency heating, and flame heating. In particular, it is preferable to use electrical resistance heating, induction heating, or high-frequency heating, which can increase the temperature in a short time and have excellent energy efficiency. As the heating furnace, any heating furnace such as an electric furnace or a gas furnace may be used.

The heated steel sheet for hot pressing is then subjected to hot press working to yield a hot-pressed member. Simultaneously with or immediately after the hot press working, the steel sheet is cooled using a coolant such as water or a mold. In the present disclosure, the hot pressing conditions are not limited. For example, pressing may be started at 600 °C to 800 °C, which is a typical hot pressing temperature range. Since the steel sheet for hot pressing according to the present disclosure has no risk of liquid metal embrittlement, it is also possible to perform forming at a higher temperature than in typical hot pressing. The hot pressing start temperature is therefore preferably 600 °C to 1000 °C.

EXAMPLES

The presently disclosed techniques will be described in more detail below by way of examples.

- Production of steel sheet for hot pressing

As a base steel sheet, a cold-rolled steel sheet of 1.4 mm in thickness having a chemical composition containing, in mass%, C: 0.34 %, Si: 0.25 %, Mn: 1.20 %, P: 0.005 %, S: 0.001 %, Al: 0.03 %, N: 0.004 %, Ti: 0.02 %, B: 0.002 %, Cr: 0.18 %, and Sb: 0.008 % with the balance consisting of Fe and inevitable impurities was used. The Ac3 transformation point of the base steel sheet was 783 °C, and the Ar3 transformation point of the base steel sheet was 706 °C.

A coating layer was formed on both sides of the base steel sheet by the method shown in Tables 1 and 2. Each of the methods used is as follows. For comparison, no coating layer was formed in Comparative Example No. 1.

(Electroplating)

The formation of the coating layer by electroplating was carried out under the following conditions. In each case, electrolysis was performed using the base steel sheet as a cathode and an iridium oxide-coated titanium sheet as an anode, and the thickness of the coating layer was adjusted by changing the current passage time.

(1) Ni plating

- Plating solution composition:

  Nickel sulfate hexahydrate 240 g/L
  Boric acid 30 g/L

- pH: 3.0
- Temperature: 50 °C
- Current density: 40 A/dm$^2$

(2) Ni-Fe alloy plating

- Plating solution composition:

  Nickel sulfate hexahydrate 192 g/L
  Iron sulfate heptahydrate 48 g/L
  Boric acid 30 g/L

- pH: 3.0
- Temperature: 50 °C
- Current density: 40 A/dm$^2$

(3) Ni-Co alloy plating

- Plating solution composition:

  Nickel sulfate hexahydrate 180 g/L
  Cobalt sulfate heptahydrate 60 g/L
  Boric acid 30 g/L

- pH: 3.0
- Temperature: 50 °C
- Current density: 40 A/dm$^2$

(4) Ni-Mo alloy plating

- Plating solution composition:

  Nickel sulfate hexahydrate 13 g/L
  Sodium molybdate dihydrate 19 g/L
  Citric acid 88 g/L

- pH: 3.5
- Temperature: 25 °C
- Current density: 10 A/dm$^2$

(5) Ni-W alloy plating

- Plating solution composition:

  Nickel sulfate hexahydrate 13 g/L
  Sodium tungsten dihydrate 30 g/L
  Citric acid 88 g/L

- pH: 3.5
- Temperature: 25 °C
- Current density: 10 A/dm$^2$

(6) Ni-Zn alloy plating

- Plating solution composition:

    Nickel sulfate hexahydrate 240 g/L
    Zinc sulfate heptahydrate

- pH: 2.0
- Temperature: 50 °C
- Current density: 40 A/dm$^2$

In the Ni-Zn alloy plating, the concentration of zinc sulfate heptahydrate in the plating solution was adjusted so that the Zn content in the coating layer would be the value shown in Tables 1 and 2.

(7) Ni-Fe-Zn alloy plating

A plating solution obtained by adding zinc sulfate heptahydrate to the plating solution of (2) Ni-Fe alloy plating was used. The concentration of zinc sulfate heptahydrate in the plating solution was adjusted so that the Zn content in the coating layer would be the value shown in Tables 1 and 2. The other conditions were the same as those of (2) Ni-Fe alloy plating.

(8) Ni-Co-Zn alloy plating

A plating solution obtained by adding zinc sulfate heptahydrate to the plating solution of (3) Ni-Co alloy plating was used. The concentration of zinc sulfate heptahydrate in the plating solution was adjusted so that the Zn content in the coating layer would be the value shown in Tables 1 and 2. The other conditions were the same as those of (3) Ni-Co alloy plating.

(9) Ni-Mo-Zn alloy plating

A plating solution obtained by adding zinc sulfate heptahydrate to the plating solution of (4) Ni-Mo alloy plating was used. The concentration of zinc sulfate heptahydrate in the plating solution was adjusted so that the Zn content in the coating layer would be the value shown in Tables 1 and 2. The other conditions were the same as those of (4) Ni-Mo alloy plating.

(10) Ni-W-Zn alloy plating

A plating solution obtained by adding zinc sulfate heptahydrate to the plating solution of (5) Ni-W alloy plating was used. The concentration of zinc sulfate heptahydrate in the plating solution was adjusted so that the Zn content in the coating layer would be the value shown in Tables 1 and 2. The other conditions were the same as those of (5) Ni-W alloy plating.

(11) Zn plating

- Plating solution composition:

    Zinc sulfate heptahydrate 240 g/L

- pH: 2.0
- Temperature: 50 °C
- Current density: 40 A/dm$^2$

(PVD)

The formation of the coating layer by PVD was carried out by ion plating using batch-type radio frequency (RF) excitation ion plating equipment produced by Showa Shinku Co., Ltd. The temperature of the base steel sheet was 400 °C, the pressure was 3 Pa, and the bias voltage was -20 V. The composition of the coating layer was controlled by adjusting the composition of the metal used as the vapor deposition source. The thickness of the coating layer was controlled by adjusting the vapor deposition time.

(Clad rolling)

A Ni-16 % Cr-8 % Fe alloy (Alloy 600) of 300 $\mu$m in thickness was stacked on both sides of a steel slab of 30 mm in thickness having the same composition as the base steel sheet, and the resultant steel slab was rolled to produce the steel sheet for hot pressing of Example No. 14.
The steel sheet for hot pressing of Example No. 30 was produced in the same manner as Example No. 14 except that a Ni-16 % Cr-8 % Fe-0.5 % Zn alloy was used as the alloy to be stacked. Likewise, the steel sheet for hot pressing of Example No. 46 was produced using a Ni-16 % Cr-8 % Fe-2 % Zn alloy as the alloy to be stacked.

(Hot-dip coating)

The formation of the coating layer by hot-dip coating was carried out by immersing the base steel sheet in a hot-dip molten bath for 1 second and then performing $N_2$ gas wiping. The composition of the coating layer was controlled by adjusting the composition of the hot-dip molten bath used.
The chemical composition and thickness of the coating layer in the steel sheet for hot pressing obtained were measured by the following methods. The measurement results are shown in Tables 1 and 2.

(Chemical composition of coating layer)

The steel sheet for hot pressing to be evaluated was sheared to collect a 10 mm $\times$ 15 mm sample. The sample was embedded in a conductive resin to prepare a cross-sectional sample of the steel sheet for hot pressing. The average composition of the coating layer from the outermost layer to the interface with the base steel sheet was measured using an EPMA. The measured values of any three samples were averaged to determine the chemical composition of the coating layer.

(Thickness of coating layer)

The thickness of the coating layer in the steel sheet for hot pressing was measured by observing the cross-sectional sample using an SEM. The thickness of the coating layer was measured at any ten locations within an observation field with a width of 100 $\mu$m or more. The measured values of any three samples were averaged to determine the thickness of the coating layer.

- Production of hot-pressed member

Next, the steel sheet for hot pressing was subjected to hot pressing. Specifically, a 200 mm $\times$ 1000 mm test piece was collected from the steel sheet for hot pressing, and the test piece was heated by a direct electrical resistance heating device. The heating was performed under the conditions of heating temperature: 950 °C, heating time: 20 seconds, and holding time: 5 seconds.
The steel sheet for hot pressing was then subjected to hat-shaped hot pressing at 2 spm (strokes per minute) using a pressing device installed adjacent to the heating furnace. The forming start temperature was 800 °C. The shape of the obtained hot-pressed member was as follows: the width of the flat part on the upper surface: 70 mm, the length of the flat part on the side surface: 30 mm, and the length of the flat part on the lower surface: 25 mm. The curvature radius of the mold was 7R for both shoulders on the upper surface and both shoulders on the lower surface.

(Chemical composition and thickness of coating layer)

The chemical composition and thickness of the coating layer in the obtained hot-pressed member were measured respectively by the same methods as the chemical composition and thickness of the coating layer in the steel sheet for hot pressing described above. A cross-sectional sample used for measurement was prepared as follows. First, the flat part of the top of the hot-pressed member was cut out and sheared to obtain a 10 mm $\times$ 15 mm sample. The sample was then embedded in a conductive resin to prepare a cross-sectional sample. The measurement results are shown in Tables 3 and 4.

Moreover, the composition and thickness of the oxide layer in the hot-pressed member were measured by the following methods. The measurement results are shown in Tables 3 and 4.

(Composition of oxide layer)

The chemical composition of the oxide layer in the hot-pressed member was measured with an EPMA. In the measurement, using the cross-sectional sample, point analysis was performed at any ten points within an observation field with a width of 100 $\mu$m or more. From the measurement results, the content (at%) of each metal element to all metal elements contained in the oxide layer was calculated.

(Thickness of oxide layer)

The thickness of the oxide layer in the hot-pressed member was measured by SEM observation using the cross-sectional sample. The thickness of the oxide layer was measured at any ten locations within an observation field with a width of 100 $\mu$m or more, and all of the measured values were averaged to determine the thickness of the oxide layer.

<Suitability for high-speed heating>

In order to evaluate the suitability of the steel sheet for hot pressing for high-speed heating, the variation in the thickness of the coating layer in the obtained hot-pressed member was measured. Specifically, first, a cross section in the width direction (short side direction) of the hat-shaped hot-pressed member was cut out and embedded in a resin. Next, the cross section was observed by SEM to obtain the coating thickness $t_C$ at the top and the coating thicknesses $t_L$ and $t_R$ at the left and right flanges. Three samples were observed for each example, and the value of I defined by the following formula (1) was calculated for each sample:

$$I = |t_C - (t_R + t_L)/2|/t_C \quad \dots (1).$$

The maximum value of I among the three samples was denoted by $I_{max}$, and was used as an index of the variation in the thickness of the coating layer in the hot-pressed member of the example. Evaluation was performed according to the following criteria using $I_{max}$. A and B were evaluated as pass. The evaluation results are shown in Tables 3 and 4.

A:

$$I_{max} \leq 0.2$$

B:

$$0.2 < I_{max} \leq 0.5$$

C:

$$I_{max} > 0.5$$

<LME cracking during forming>

In order to evaluate liquid metal embrittlement cracking during hot press forming, cracking in the obtained hot-pressed member was measured. Specifically, first, the shoulder part on the upper surface of the hat-shaped hot-pressed member was cut out, embedded in a resin, and then etched with 3 % nital. A cross section was then observed, and the depth of cracks extending from the surface of the shoulder part to the inside in the thickness direction was measured. For each example, three samples were observed, and evaluation was performed according to the following criteria based on the length of the longest crack. A, B, and C were evaluated as pass. The evaluation results are shown in Tables 3 and 4.

A:

$$\text{Maximum crack length} = 0 \text{ mm}$$

B:

$$0 \text{ mm} < \text{Maximum crack length} \leq 0.01 \text{ mm}$$

C:

$$0.01 \text{ mm} < \text{Maximum crack length} \leq 0.1 \text{ mm}$$

D:

$$\text{Maximum crack length} > 0.1 \text{ mm}$$

<Paint adhesion>

The electrodeposition paint (coating) adhesion of the obtained hot-pressed member was evaluated by the following procedure. First, a sample was prepared by performing zinc phosphate chemical conversion treatment and electrodeposition painting (coating) on a test piece cut out from the flat part on the upper surface of the hot-pressed member. Next, a peel test of 25 1 mmwide grid squares was performed to evaluate electrodeposition paint adhesion, using the cross-cut adhesion evaluation method specified in JIS K 5600-5-6

(1999). The results were determined by rating, with A and B evaluated as pass. The evaluation results are shown in Tables 3 and 4.

A: Rating 5
B: Rating 4
C: Rating 3
D: Rating 2 or less

As can be seen from the results shown in Tables 1 to 4, each steel sheet for hot pressing satisfying the conditions according to the present disclosure did not vary in the thickness of the coating layer even when heated at high speed, and thus had high suitability for high-speed heating. In addition, each steel sheet for hot pressing satisfying the conditions according to the present disclosure was prevented from liquid metal embrittlement cracking during hot press forming. The hot-pressed member obtained by hot-pressing each steel sheet for hot pressing according to the present disclosure had excellent paint adhesion.

[Table 1]

Table 1

| No. | Steel sheet for hot pressing | | | | | | | | | | | | Remarks |
| | Coating layer | | | | | | | | | | | | |
| | Formation method | Chemical composition (mass%) | | | | | | | | | | Thickness (μm) | |
| | | Ni | Al | Ti | Cr | Mn | Fe | Co | Mo | w | Zn | | |
| 1 | - | - | - | - | - | - | - | - | - | - | - | <u>-</u> | Comparative Example |
| 2 | Electroplating | 100 | 0 | 0 | 0 | 0 | 0 | 0 | 0 | 0 | 0 | <u>0.3</u> | Comparative Example |
| 3 | Electroplating | 100 | 0 | 0 | 0 | 0 | 0 | 0 | 0 | 0 | 0 | 0.6 | Example |
| 4 | Electroplating | 100 | 0 | 0 | 0 | 0 | 0 | 0 | 0 | 0 | 0 | 1.0 | Example |
| 5 | Electroplating | 100 | 0 | 0 | 0 | 0 | 0 | 0 | 0 | 0 | 0 | 3.0 | Example |
| 6 | Electroplating | 100 | 0 | 0 | 0 | 0 | 0 | 0 | 0 | 0 | 0 | 5.0 | Example |

(continued)

| No. | Steel sheet for hot pressing | | | | | | | | | | | | Remarks |
|---|---|---|---|---|---|---|---|---|---|---|---|---|---|
| | Coating layer | | | | | | | | | | | | |
| | Formation method | Chemical composition (mass%) | | | | | | | | | | Thickness (μm) | |
| | | Ni | Al | Ti | Cr | Mn | Fe | Co | Mo | w | Zn | | |
| 7 | Electroplating | 100 | 0 | 0 | 0 | 0 | 0 | 0 | 0 | 0 | 0 | 7.0 | Comparative Example |
| 8 | Electroplating | 100 | 0 | 0 | 0 | 0 | 0 | 0 | 0 | 0 | 0 | 10 | Comparative Example |
| 9 | PVD | 80 | 20 | 0 | 0 | 0 | 0 | 0 | 0 | 0 | 0 | 3.0 | Example |
| 10 | PVD | 80 | 0 | 20 | 0 | 0 | 0 | 0 | 0 | 0 | 0 | 3.0 | Example |
| 11 | PVD | 80 | 0 | 0 | 20 | 0 | 0 | 0 | 0 | 0 | 0 | 3.0 | Example |
| 12 | PVD | 80 | 0 | 0 | 0 | 20 | 0 | 0 | 0 | 0 | 0 | 3.0 | Example |
| 13 | PVD | 80 | 0 | 0 | 10 | 0 | 0 | 10 | 0 | 0 | 0 | 3.0 | Example |
| 14 | Clad rolling | 76 | 0 | 0 | 16 | 0 | 8 | 0 | 0 | 0 | 0 | 3.0 | Example |
| 15 | Electroplating | 80 | 0 | 0 | 0 | 0 | 20 | 0 | 0 | 0 | 0 | 3.0 | Example |
| 16 | Electroplating | 80 | 0 | 0 | 0 | 0 | 0 | 20 | 0 | 0 | 0 | 3.0 | Example |
| 17 | Electroplating | 80 | 0 | 0 | 0 | 0 | 0 | 0 | 20 | 0 | 0 | 3.0 | Example |
| 18 | Electroplating | 80 | 0 | 0 | 0 | 0 | 0 | 0 | 0 | 20 | 0 | 3.0 | Example |
| 19 | Electroplating | 99.5 | 0 | 0 | 0 | 0 | 0 | 0 | 0 | 0 | 0.5 | 0.6 | Example |
| 20 | Electroplating | 99.5 | 0 | 0 | 0 | 0 | 0 | 0 | 0 | 0 | 0.5 | 1.0 | Example |
| 21 | Electroplating | 99.5 | 0 | 0 | 0 | 0 | 0 | 0 | 0 | 0 | 0.5 | 3.0 | Example |
| 22 | Electroplating | 99.5 | 0 | 0 | 0 | 0 | 0 | 0 | 0 | 0 | 0.5 | 5.0 | Example |
| 23 | Electroplating | 99.5 | 0 | 0 | 0 | 0 | 0 | 0 | 0 | 0 | 0.5 | 7.0 | Comparative Example |
| 24 | Electroplating | 99.5 | 0 | 0 | 0 | 0 | 0 | 0 | 0 | 0 | 0.5 | 10 | Comparative Example |
| 25 | PVD | 79.5 | 20 | 0 | 0 | 0 | 0 | 0 | 0 | 0 | 0.5 | 3.0 | Example |
| 26 | PVD | 79.5 | 0 | 20 | 0 | 0 | 0 | 0 | 0 | 0 | 0.5 | 3.0 | Example |
| 27 | PVD | 79.5 | 0 | 0 | 20 | 0 | 0 | 0 | 0 | 0 | 0.5 | 3.0 | Example |
| 28 | PVD | 79.5 | 0 | 0 | 0 | 20 | 0 | 0 | 0 | 0 | 0.5 | 3.0 | Example |
| 29 | PVD | 79.5 | 0 | 0 | 10 | 0 | 0 | 10 | 0 | 0 | 0.5 | 3.0 | Example |

[Table 2]

Table 2

| No. | Steel sheet for hot pressing | | | | | | | | | | | | Remarks |
|---|---|---|---|---|---|---|---|---|---|---|---|---|---|
| | Coating layer | | | | | | | | | | | | |
| | Formation method | Chemical composition (mass%) | | | | | | | | | | Thickness (μm) | |
| | | Ni | Al | Ti | Cr | Mn | Fe | Co | Mo | W | Zn | | |
| 30 | Clad rolling | 75.5 | 0 | 0 | 16 | 0 | 8 | 0 | 0 | 0 | 0.5 | 3.0 | Example |
| 31 | Electroplating | 79.5 | 0 | 0 | 0 | 0 | 20 | 0 | 0 | 0 | 0.5 | 3.0 | Example |
| 32 | Electroplating | 79.5 | 0 | 0 | 0 | 0 | 0 | 20 | 0 | 0 | 0.5 | 3.0 | Example |
| 33 | Electroplating | 79.5 | 0 | 0 | 0 | 0 | 0 | 0 | 20 | 0 | 0.5 | 3.0 | Example |
| 34 | Electroplating | 79.5 | 0 | 0 | 0 | 0 | 0 | 0 | 0 | 20 | 0.5 | 3.0 | Example |

(continued)

| No. | \multicolumn{12}{c}{Steel sheet for hot pressing} | Remarks |
|---|---|---|---|---|---|---|---|---|---|---|---|---|---|
| | Formation method | \multicolumn{10}{c}{Coating layer} | | |
| | | \multicolumn{10}{c}{Chemical composition (mass%)} | Thickness (μm) | |
| | | Ni | Al | Ti | Cr | Mn | Fe | Co | Mo | W | Zn | | |
| 35 | Electroplating | 98 | 0 | 0 | 0 | 0 | 0 | 0 | 0 | 0 | 2 | 0.6 | Example |
| 36 | Electroplating | 98 | 0 | 0 | 0 | 0 | 0 | 0 | 0 | 0 | 2 | 1.0 | Example |
| 37 | Electroplating | 98 | 0 | 0 | 0 | 0 | 0 | 0 | 0 | 0 | 2 | 3.0 | Example |
| 38 | Electroplating | 98 | 0 | 0 | 0 | 0 | 0 | 0 | 0 | 0 | 2 | 5.0 | Example |
| 39 | Electroplating | 98 | 0 | 0 | 0 | 0 | 0 | 0 | 0 | 0 | 2 | 7.0 | Comparative Example |
| 40 | Electroplating | 98 | 0 | 0 | 0 | 0 | 0 | 0 | 0 | 0 | 2 | 10 | Comparative Example |
| 41 | PVD | 78 | 20 | 0 | 0 | 0 | 0 | 0 | 0 | 0 | 2 | 3.0 | Example |
| 42 | PVD | 78 | 0 | 20 | 0 | 0 | 0 | 0 | 0 | 0 | 2 | 3.0 | Example |
| 43 | PVD | 78 | 0 | 0 | 20 | 0 | 0 | 0 | 0 | 0 | 2 | 3.0 | Example |
| 44 | PVD | 78 | 0 | 0 | 0 | 20 | 0 | 0 | 0 | 0 | 2 | 3.0 | Example |
| 45 | PVD | 78 | 0 | 0 | 10 | 0 | 0 | 10 | 0 | 0 | 2 | 3.0 | Example |
| 46 | Clad rolling | 74 | 0 | 0 | 16 | 0 | 8 | 0 | 0 | 0 | 2 | 3.0 | Example |
| 47 | Electroplating | 78 | 0 | 0 | 0 | 0 | 20 | 0 | 0 | 0 | 2 | 3.0 | Example |
| 48 | Electroplating | 78 | 0 | 0 | 0 | 0 | 0 | 20 | 0 | 0 | 2 | 3.0 | Example |
| 49 | Electroplating | 78 | 0 | 0 | 0 | 0 | 0 | 0 | 20 | 0 | 2 | 3.0 | Example |
| 50 | Electroplating | 78 | 0 | 0 | 0 | 0 | 0 | 0 | 0 | 20 | 2 | 3.0 | Example |
| 51 | Electroplating | 95 | 0 | 0 | 0 | 0 | 0 | 0 | 0 | 0 | 5 | 3.0 | Example |
| 52 | Electroplating | 90 | 0 | 0 | 0 | 0 | 0 | 0 | 0 | 0 | 10 | 3.0 | Example |
| 53 | Electroplating | 75 | 0 | 0 | 0 | 0 | 0 | 0 | 0 | 0 | 25 | 3.0 | Example |
| 54 | Electroplating | 50 | 0 | 0 | 0 | 0 | 0 | 0 | 0 | 0 | 50 | 3.0 | Comparative Example |
| 55 | Hot-dip coating | 0 | 0 | 0 | 0 | 0 | 10 | 0 | 0 | 0 | 90 | 5.0 | Comparative Example |
| 56 | Electroplating | 0 | 0 | 0 | 0 | 0 | 0 | 0 | 0 | 0 | 100 | 5.0 | Comparative Example |
| 57 | Hot-dip coating | \multicolumn{10}{c}{Al-10%Si-3%Fe} | 25 | Comparative Example |
| 58 | Hot-dip coating | \multicolumn{10}{c}{Zn-55%Al-1.6%Si} | 25 | Comparative Example |

[Table 3]

Table 3

| No. | Hot-pressed member | | | | | | | | | | | | | | | | | | | | | | Evaluation | | | Remarks |
|---|---|---|---|---|---|---|---|---|---|---|---|---|---|---|---|---|---|---|---|---|---|---|---|---|---|---|
| | Coating layer | | | | | | | | | | | Oxide layer | | | | | | | | | | | | | | |
| | Chemical composition (mass%) | | | | | | | | | | Thickness (μm) | Ratio to all metals (at%) | | | | | | | | | | Thickness (μm) | Suitability for high-speed heating | LME cracking during forming | Paint adhesion | |
| | Ni | Al | Ti | Cr | Mn | Fe | Co | Mo | W | Zn | | Ni | Al | Ti | Cr | Mn | Fe | Co | Mo | W | Zn | | | | | |
| 1 | - | - | - | - | - | - | - | - | - | - | - | 0 | 0 | 0 | 0 | 0 | 100 | 0 | 0 | 0 | 0 | 25.0 | A | A | D | Comparative Example |
| 2 | - | - | - | - | - | - | - | - | - | - | 0.0 | 50 | 0 | 0 | 0 | 0 | 50 | 0 | 0 | 0 | 0 | 8.0 | A | A | C | Comparative Example |
| 3 | 100 | 0 | 0 | 0 | 0 | 0 | 0 | 0 | 0 | 0 | 0.5 | 60 | 0 | 0 | 0 | 2 | 38 | 0 | 0 | 0 | 0 | 4.0 | A | A | B | Example |
| 4 | 100 | 0 | 0 | 0 | 0 | 0 | 0 | 0 | 0 | 0 | 0.8 | 70 | 0 | 0 | 0 | 2 | 28 | 0 | 0 | 0 | 0 | 3.0 | A | A | A | Example |
| 5 | 100 | 0 | 0 | 0 | 0 | 0 | 0 | 0 | 0 | 0 | 2.5 | 80 | 0 | 0 | 0 | 1 | 19 | 0 | 0 | 0 | 0 | 2.0 | A | A | A | Example |
| 6 | 100 | 0 | 0 | 0 | 0 | 0 | 0 | 0 | 0 | 0 | 4.0 | 90 | 0 | 0 | 0 | 1 | 9 | 0 | 0 | 0 | 0 | 1.0 | A | A | B | Example |
| 7 | 90 | 0 | 0 | 0 | 0 | 10 | 0 | 0 | 0 | 0 | 6.4 | 95 | 0 | 0 | 0 | 0 | 5 | 0 | 0 | 0 | 0 | 1.0 | A | A | C | Comparative Example |
| 8 | 90 | 0 | 0 | 0 | 0 | 10 | 0 | 0 | 0 | 0 | 8.0 | 100 | 0 | 0 | 0 | 0 | 0 | 0 | 0 | 0 | 0 | 1.0 | A | A | D | Comparative Example |
| 9 | 90 | 0 | 0 | 0 | 0 | 10 | 0 | 0 | 0 | 0 | 2.9 | 90 | 0 | 0 | 0 | 1 | 9 | 0 | 0 | 0 | 0 | 1.7 | A | A | A | Example |
| 10 | 72 | 18 | 0 | 0 | 0 | 10 | 0 | 0 | 0 | 0 | 2.8 | 50 | 40 | 0 | 0 | 1 | 9 | 0 | 0 | 0 | 0 | 1.5 | A | A | A | Example |
| 11 | 72 | 0 | 18 | 0 | 0 | 10 | 0 | 0 | 0 | 0 | 2.8 | 50 | 0 | 40 | 0 | 1 | 9 | 0 | 0 | 0 | 0 | 1.5 | A | A | A | Example |
| 12 | 72 | 0 | 0 | 18 | 0 | 10 | 0 | 0 | 0 | 0 | 2.6 | 50 | 0 | 0 | 40 | 1 | 9 | 0 | 0 | 0 | 0 | 1.8 | A | A | A | Example |
| 13 | 72 | 0 | 0 | 0 | 18 | 10 | 0 | 0 | 0 | 0 | 2.6 | 50 | 0 | 0 | 0 | 40 | 10 | 0 | 0 | 0 | 0 | 1.8 | A | A | A | Example |
| 14 | 77 | 0 | 0 | 16 | 0 | 7 | 0 | 0 | 0 | 0 | 2.9 | 55 | 0 | 0 | 25 | 1 | 19 | 0 | 0 | 0 | 0 | 1.5 | A | A | A | Example |
| 15 | 85 | 0 | 0 | 0 | 0 | 15 | 0 | 0 | 0 | 0 | 2.7 | 80 | 0 | 0 | 0 | 1 | 19 | 0 | 0 | 0 | 0 | 1.5 | A | A | A | Example |
| 16 | 72 | 0 | 0 | 0 | 0 | 10 | 18 | 0 | 0 | 0 | 2.7 | 55 | 0 | 0 | 0 | 1 | 9 | 35 | 0 | 0 | 0 | 1.5 | A | A | A | Example |
| 17 | 72 | 0 | 0 | 0 | 0 | 10 | 0 | 18 | 0 | 0 | 2.7 | 55 | 0 | 0 | 0 | 1 | 9 | 0 | 35 | 0 | 0 | 1.5 | A | A | A | Example |
| 18 | 72 | 0 | 0 | 0 | 0 | 10 | 0 | 0 | 18 | 0 | 2.7 | 55 | 0 | 0 | 0 | 1 | 9 | 0 | 0 | 35 | 0 | 1.5 | A | A | A | Example |
| 19 | 99.5 | 0 | 0 | 0 | 0 | 0 | 0 | 0 | 0 | 0.5 | 0.5 | 59 | 0 | 0 | 0 | 2 | 38 | 0 | 0 | 0 | 1 | 4.0 | A | A | B | Example |
| 20 | 99.5 | 0 | 0 | 0 | 0 | 0 | 0 | 0 | 0 | 0.5 | 0.8 | 69 | 0 | 0 | 0 | 2 | 28 | 0 | 0 | 0 | 1 | 3.0 | A | A | A | Example |
| 21 | 99.5 | 0 | 0 | 0 | 0 | 0 | 0 | 0 | 0 | 0.5 | 2.5 | 79 | 0 | 0 | 0 | 1 | 19 | 0 | 0 | 0 | 1 | 2.0 | A | A | A | Example |
| 22 | 99.5 | 0 | 0 | 0 | 0 | 0 | 0 | 0 | 0 | 0.5 | 4.0 | 89 | 0 | 0 | 0 | 1 | 9 | 0 | 0 | 0 | 1 | 1.0 | A | A | B | Example |
| 23 | 99.5 | 0 | 0 | 0 | 0 | 0 | 0 | 0 | 0 | 0.5 | 6.4 | 94 | 0 | 0 | 0 | 0 | 5 | 0 | 0 | 0 | 1 | 1.0 | A | A | C | Comparative Example |
| 24 | 99.5 | 0 | 0 | 0 | 0 | 0 | 0 | 0 | 0 | 0.5 | 8.0 | 99 | 0 | 0 | 0 | 0 | 0 | 0 | 0 | 0 | 1 | 1.0 | A | A | D | Comparative Example |
| 25 | 79.5 | 0 | 0 | 0 | 0 | 20 | 0 | 0 | 0 | 0.5 | 2.9 | 89 | 0 | 0 | 0 | 1 | 9 | 0 | 0 | 0 | 1 | 1.7 | A | A | A | Example |
| 26 | 79.5 | 18 | 0 | 0 | 0 | 0 | 0 | 0 | 0 | 0.5 | 2.8 | 49 | 40 | 0 | 0 | 1 | 9 | 0 | 0 | 0 | 1 | 1.5 | A | A | A | Example |
| 27 | 79.5 | 0 | 18 | 0 | 0 | 0 | 0 | 0 | 0 | 0.5 | 2.8 | 49 | 0 | 40 | 0 | 1 | 9 | 0 | 0 | 0 | 1 | 1.5 | A | A | A | Example |
| 28 | 79.5 | 0 | 0 | 0 | 18 | 0 | 0 | 0 | 0 | 0.5 | 2.6 | 49 | 0 | 0 | 0 | 40 | 10 | 0 | 0 | 0 | 1 | 1.8 | A | A | A | Example |
| 29 | 79.5 | 0 | 0 | 0 | 0 | 10 | 9 | 0 | 0 | 0.5 | 2.6 | 54 | 0 | 0 | 0 | 1 | 9 | 35 | 0 | 0 | 1 | 1.8 | A | A | A | Example |

[Table 4]

Table 4

| No. | Coating layer – Chemical composition (mass%) Ni | Al | Ti | Cr | Mn | Fe | Co | Mo | W | Zn | Thickness (μm) | Oxide layer – Ratio to all metals (at%) Ni | Al | Ti | Cr | Mn | Fe | Co | Mo | W | Zn | Thickness (μm) | Suitability for high-speed heating | LME cracking during forming | Paint adhesion | Remarks |
|---|---|---|---|---|---|---|---|---|---|---|---|---|---|---|---|---|---|---|---|---|---|---|---|---|---|---|
| 30 | 75.5 | 0 | 0 | 16 | 0 | 7 | 0 | 0 | 0 | 0.5 | 2.9 | 54 | 0 | 0 | 25 | 1 | 19 | 0 | 0 | 0 | 1 | 1.5 | A | A | A | Example |
| 31 | 79.5 | 0 | 0 | 0 | 0 | 15 | 0 | 0 | 0 | 0.5 | 2.7 | 79 | 0 | 0 | 0 | 1 | 19 | 0 | 0 | 0 | 1 | 1.5 | A | A | A | Example |
| 32 | 79.5 | 0 | 0 | 0 | 0 | 10 | 18 | 0 | 0 | 0.5 | 2.7 | 54 | 0 | 0 | 0 | 1 | 9 | 35 | 0 | 0 | 1 | 1.5 | A | A | A | Example |
| 33 | 79.5 | 0 | 0 | 0 | 0 | 10 | 0 | 18 | 0 | 0.5 | 2.7 | 54 | 0 | 0 | 0 | 1 | 9 | 0 | 35 | 0 | 1 | 1.5 | A | A | A | Example |
| 34 | 79.5 | 0 | 0 | 0 | 0 | 10 | 0 | 0 | 18 | 0.5 | 2.7 | 54 | 0 | 0 | 0 | 1 | 9 | 0 | 0 | 35 | 1 | 1.5 | A | A | A | Example |
| 35 | 98 | 0 | 0 | 0 | 0 | 0 | 0 | 0 | 0 | 2 | 0.5 | 55 | 0 | 0 | 0 | 2 | 38 | 0 | 0 | 0 | 5 | 4.0 | A | A | B | Example |
| 36 | 98 | 0 | 0 | 0 | 0 | 0 | 0 | 0 | 0 | 2 | 0.8 | 65 | 0 | 0 | 0 | 2 | 28 | 0 | 0 | 0 | 5 | 3.0 | A | A | A | Example |
| 37 | 98 | 0 | 0 | 0 | 0 | 0 | 0 | 0 | 0 | 2 | 2.5 | 75 | 0 | 0 | 0 | 1 | 19 | 0 | 0 | 0 | 5 | 2.0 | A | A | A | Example |
| 38 | 98 | 0 | 0 | 0 | 0 | 0 | 0 | 0 | 0 | 2 | 4.0 | 85 | 0 | 0 | 0 | 1 | 9 | 0 | 0 | 0 | 5 | 1.0 | A | A | B | Example |
| 39 | 98 | 0 | 0 | 0 | 0 | 0 | 0 | 0 | 0 | 2 | 6.4 | 90 | 0 | 0 | 0 | 0 | 5 | 0 | 0 | 0 | 5 | 1.0 | A | A | C | Comparative Example |
| 40 | 98 | 0 | 0 | 0 | 0 | 0 | 0 | 0 | 0 | 2 | 8.0 | 95 | 0 | 0 | 0 | 0 | 0 | 0 | 0 | 0 | 5 | 1.0 | A | A | D | Comparative Example |
| 41 | 78 | 18 | 0 | 0 | 0 | 10 | 0 | 0 | 0 | 2 | 2.9 | 45 | 40 | 0 | 0 | 1 | 9 | 0 | 0 | 0 | 5 | 1.7 | A | A | A | Example |
| 42 | 78 | 0 | 18 | 0 | 0 | 10 | 0 | 0 | 0 | 2 | 2.8 | 45 | 0 | 40 | 0 | 1 | 9 | 0 | 0 | 0 | 5 | 1.5 | A | A | A | Example |
| 43 | 78 | 0 | 0 | 18 | 0 | 10 | 0 | 0 | 0 | 2 | 2.8 | 45 | 0 | 0 | 40 | 0 | 10 | 0 | 0 | 0 | 5 | 1.5 | A | A | A | Example |
| 44 | 78 | 0 | 0 | 0 | 18 | 10 | 0 | 0 | 0 | 2 | 2.6 | 45 | 0 | 0 | 0 | 40 | 10 | 0 | 0 | 0 | 5 | 1.8 | A | A | A | Example |
| 45 | 78 | 0 | 0 | 0 | 0 | 10 | 9 | 0 | 0 | 2 | 2.6 | 50 | 0 | 0 | 0 | 1 | 9 | 35 | 0 | 0 | 5 | 1.8 | A | A | A | Example |
| 46 | 74 | 0 | 0 | 9 | 0 | 7 | 0 | 0 | 0 | 2 | 2.9 | 50 | 0 | 0 | 0 | 1 | 9 | 0 | 35 | 0 | 5 | 1.5 | A | A | A | Example |
| 47 | 78 | 0 | 0 | 16 | 0 | 15 | 0 | 0 | 0 | 2 | 2.7 | 50 | 0 | 0 | 25 | 1 | 19 | 0 | 0 | 0 | 5 | 1.5 | A | A | A | Example |
| 48 | 78 | 0 | 0 | 0 | 0 | 10 | 18 | 0 | 0 | 2 | 2.7 | 50 | 0 | 0 | 0 | 1 | 9 | 35 | 0 | 0 | 5 | 1.5 | A | A | A | Example |
| 49 | 78 | 0 | 0 | 0 | 0 | 10 | 0 | 18 | 0 | 2 | 2.7 | 50 | 0 | 0 | 0 | 1 | 9 | 0 | 35 | 0 | 5 | 1.5 | A | A | A | Example |
| 50 | 78 | 0 | 0 | 0 | 0 | 10 | 0 | 0 | 18 | 2 | 2.7 | 50 | 0 | 0 | 0 | 1 | 9 | 0 | 0 | 35 | 5 | 1.5 | A | A | A | Example |
| 51 | 89 | 0 | 0 | 0 | 0 | 10 | 0 | 0 | 0 | 1 | 2.8 | 80 | 0 | 0 | 0 | 1 | 9 | 0 | 0 | 0 | 10 | 1.6 | A | A | A | Example |
| 52 | 80 | 0 | 0 | 0 | 0 | 10 | 0 | 0 | 0 | 10 | 2.8 | 15 | 0 | 0 | 0 | 1 | 9 | 0 | 0 | 0 | 75 | 1.6 | A | B | B | Example |
| 53 | 68 | 0 | 0 | 0 | 0 | 10 | 0 | 0 | 0 | 22 | 2.8 | 10 | 0 | 0 | 0 | 1 | 9 | 0 | 0 | 0 | 80 | 1.6 | A | B | A | Example |
| 54 | 55 | 0 | 0 | 0 | 0 | 10 | 0 | 0 | 0 | 35 | 2.8 | 5 | 0 | 0 | 0 | 1 | 9 | 0 | 0 | 0 | 85 | 1.6 | A | D | A | Comparative Example |
| 55 | 0 | 0 | 0 | 0 | 0 | 50 | 0 | 0 | 0 | 50 | 4.5 | 0 | 0 | 0 | 0 | 1 | 9 | 0 | 0 | 0 | 90 | 3.0 | B | D | A | Comparative Example |
| 56 | 0 | 0 | 0 | 0 | 0 | 40 | 0 | 0 | 0 | 60 | 4.5 | 0 | 0 | 0 | 0 | 1 | 9 | 0 | 0 | 0 | 90 | 3.0 | B | D | A | Comparative Example |
| 57 | Fe-Al-Si | | | | | | | | | | 30.0 | - | - | - | - | - | - | - | - | - | - | 0.0 | C | A | C | Comparative Example |
| 58 | Fe-Al-Zn-Si | | | | | | | | | | 30.0 | 0 | 0 | 0 | 0 | 0 | 0 | 0 | 0 | 0 | 100 | 3.0 | C | B | B | Comparative Example |

**Claims**

1. A steel sheet for hot pressing, comprising:

   a base steel sheet; and
   a coating layer of 0.5 $\mu$m to 6.0 $\mu$m in thickness provided on both sides of the base steel sheet,
   wherein the coating layer is made of Ni or a Ni-based alloy, and a Zn content in the coating layer is 0 mass% to 30 mass%.

2. The steel sheet for hot pressing according to claim 1, wherein the Zn content in the coating layer is 0.5 mass% to 30 mass%.

3. The steel sheet for hot pressing according to claim 1 or 2, wherein the coating layer contains at least one selected from the group consisting of Al, Ti, V, Cr, Mn, Fe, Co, Mo, and W in a total amount of 50 mass% or less.

4. A hot-pressed member comprising:

   a base steel sheet; and
   a coating layer of 0.5 $\mu$m to 6.0 $\mu$m in thickness provided on both sides of the base steel sheet,
   wherein the coating layer is made of Ni or a Ni-based alloy, and a Zn content in the coating layer is 0 mass% to 30 mass%.

5. The hot-pressed member according to claim 4, wherein the Zn content in the coating layer is 0.5 mass% to 30 mass%.

6. The hot-pressed member according to claim 4 or 5, wherein the coating layer contains at least one selected from the group consisting of Al, Ti, V, Cr, Mn, Fe, Co, Mo, and W in a total amount of 50 mass% or less.

7. The hot-pressed member according to any one of claims 4 to 6, further comprising an oxide layer containing one or both of Mn and Fe and having a thickness of 0.1 $\mu$m to 5 $\mu$m, on the coating layer,
   wherein a total ratio of Mn and Fe to all metal elements contained in the oxide layer is 1 at% to 50 at%.

8. A hot-pressed member production method comprising hot pressing the steel sheet for hot pressing according to any one of claims 1 to 3 to obtain a hot-pressed member.

**EP 4 541 938 A1**

## INTERNATIONAL SEARCH REPORT

| International application No. |
|---|
| **PCT/JP2023/023229** |

### A. CLASSIFICATION OF SUBJECT MATTER

*C23C 26/00*(2006.01)i; *C21D 1/18*(2006.01)i; *C21D 9/00*(2006.01)i; *C22C 19/03*(2006.01)i; *C22C 19/05*(2006.01)i; *C22C 38/00*(2006.01)i; *C22C 38/06*(2006.01)i; *C22C 38/60*(2006.01)i; *C23C 14/14*(2006.01)i; *C23C 14/16*(2006.01)i; *C23C 28/00*(2006.01)i; *C25D 5/26*(2006.01)i; *C25D 5/48*(2006.01)i

FI: C23C26/00 B; C21D1/18 C; C21D9/00 A; C22C19/03 G; C22C19/05 B; C22C38/00 301T; C22C38/06; C22C38/60; C23C14/14 D; C23C14/16 A; C23C28/00 B; C25D5/26 A; C25D5/26 E; C25D5/26 G; C25D5/48

According to International Patent Classification (IPC) or to both national classification and IPC

### B. FIELDS SEARCHED

Minimum documentation searched (classification system followed by classification symbols)

C23C26/00; C21D1/18; C21D9/00; C22C19/03; C22C19/05; C22C38/00; C22C38/06; C22C38/60; C23C14/14; C23C14/16; C23C28/00; C25D5/26; C25D5/48

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X | JP 2011-122207 A (JFE STEEL CORP) 23 June 2011 (2011-06-23) | 1, 4, 8 |
| | claims, paragraphs [0003], [0023]-[0024], [0048]-[0051] | |
| Y | | 3, 6 |
| A | | 2, 5, 7 |
| X | JP 2012-197505 A (JFE STEEL CORP) 18 October 2012 (2012-10-18) | 1, 4, 8 |
| | claims, paragraphs [0003], [0019], [0040]-[0044] | |
| Y | | 3, 6 |
| A | | 2, 5, 7 |
| Y | JP 2019-518136 A (ARCELORMITTAL ) 27 June 2019 (2019-06-27) | 3, 6 |
| | claims, paragraph [0024] | |

☐ Further documents are listed in the continuation of Box C.　　☑ See patent family annex.

| | |
|---|---|
| \* Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **03 August 2023** | **15 August 2023** |

| Name and mailing address of the ISA/JP | Authorized officer |
|---|---|
| **Japan Patent Office (ISA/JP)** **3-4-3 Kasumigaseki, Chiyoda-ku, Tokyo 100-8915 Japan** | |
| | Telephone No. |

Form PCT/ISA/210 (second sheet) (January 2015)

INTERNATIONAL SEARCH REPORT
Information on patent family members

International application No.

**PCT/JP2023/023229**

| Patent document<br>cited in search report | | | Publication date<br>(day/month/year) | Patent family member(s) | | | Publication date<br>(day/month/year) |
|---|---|---|---|---|---|---|---|
| JP | 2011-122207 | A | 23 June 2011 | WO | 2011/070877 | A1 | |
| | | | | TW | 201127967 | A | |
| | | | | KR | 10-2012-0065428 | A | |
| | | | | CN | 102686779 | A | |
| JP | 2012-197505 | A | 18 October 2012 | EP | 2684985 | A1 | |
| | | | | claims, paragraphs [0003],<br>[0019], [0040]-[0044] | | | |
| | | | | WO | 2012/121399 | A1 | |
| | | | | TW | 201243106 | A | |
| JP | 2019-518136 | A | 27 June 2019 | US | 2019/0144963 | A1 | |
| | | | | claims, paragraph [0076] | | | |
| | | | | WO | 2017/187215 | A1 | |
| | | | | KR | 10-2018-0122731 | A | |
| | | | | CN | 109072450 | A | |
| | | | | EP | 3633068 | A1 | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2000038640 A